(19) Europäisches Patentamt
European Patent Office
Office européen des brevets

(11) **EP 4 181 215 A1**

(12) **EUROPEAN PATENT APPLICATION**

(43) Date of publication:
**17.05.2023 Bulletin 2023/20**

(21) Application number: **21213757.4**

(22) Date of filing: **10.12.2021**

(51) International Patent Classification (IPC):
*H01L 31/0224* (2006.01) *H01L 31/05* (2014.01)

(52) Cooperative Patent Classification (CPC):
**H01L 31/022425; H01L 31/0504**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.11.2021 CN 202111324216**

(71) Applicants:
• **Zhejiang Jinko Solar Co., Ltd.**
**Haining, Zhejiang 314416 (CN)**
• **JINKO SOLAR CO., LTD**
**Jiangxi 334100 (CN)**

(72) Inventors:
• GUO, Zhiqiu
**Haining, Zhejiang, 314416 (CN)**
• HUANG, Shiliang
**Haining, Zhejiang, 314416 (CN)**
• ZHU, Jiaming
**Haining, Zhejiang, 314416 (CN)**

(74) Representative: **Rösler Rasch van der Heide & Partner**
**Bodenseestraße 18**
**81241 München (DE)**

Remarks:
Amended claims in accordance with Rule 137(2) EPC.

(54) **SOLAR CELL AND PHOTOVOLTAIC MODULE**

(57) Provided is a solar cell and a photovoltaic module. The solar cell includes a semiconductor substrate and an electrode arranged on the semiconductor substrate. The electrode includes a plurality of fingers arranged in parallel to and spaced apart from each other. Each finger includes a transport electrode line and a plurality of electrical connection electrode lines in contact with the transport electrode line. In a thickness direction of the semiconductor substrate, a plurality of fingers on a light receiving surface of the semiconductor substrate are staggered with a plurality of fingers on a backlight surface of the semiconductor substrate.

FIG. 1

EP 4 181 215 A1

**Description**

**TECHNICAL FIELD**

The present disclosure relates to the technical field of solar cells, and in particular, to a solar cell and a photovoltaic module.

**BACKGROUND**

With the mature development of the photovoltaic industry, a multi-busbar technology has become an industry standard. Multi busbars may reduce light shielding of a surface of a solar cell, increase a light receiving area, reduce a usage amount of silver paste when the number of finger is reduced, and shorten a conduction distance of a current on fingers, thereby effectively reducing series resistance of a module and reducing resistance loss. However, the multi busbars may lead to use of more silver paste under a condition that the number of finger is unchanged or increased while increasing a light shielding area of the solar cell, so that space for cost reduction is getting smaller.

**SUMMARY**

In view of the above problems, the present disclosure provides a solar cell and a photovoltaic module to solve the technical problems in the related art, which can reduce light shielding of a surface of the solar cell and consumption of silver paste and ensure reliability of soldering of the solar cell.

In a first aspect, the present disclosure provides a solar cell, including a semiconductor substrate, and an electrode arranged on the semiconductor substrate. The electrode includes a plurality of fingers arranged in parallel to and spaced apart from each other. Each finger of the plurality of finger includes a transport electrode line and a plurality of electrical connection electrode lines in contact with the transport electrode line. In a thickness direction of the semiconductor substrate, a plurality of fingers arranged on a light receiving surface of the semiconductor substrate are staggered with a plurality of fingers arranged on a backlight surface of the semiconductor substrate.

In some embodiments, a size of the electrode satisfies $L1+2 \text{ mm} \geq L1' \geq L1+0.5 \text{ mm}$, and $L2-2 \text{ mm} \leq L2' \leq L2-0.5$ mm. L1 represents a spacing between an edge of a first side on the light receiving surface of the semiconductor substrate to the finger adjacent thereto, L2 represents a spacing between an edge of a second side on the light receiving surface of the semiconductor substrate to the finger adjacent thereto, L1' represents a spacing between an edge of a first side on the backlight surface of the semiconductor substrate to the finger adjacent thereto, and L2' represents a spacing between an edge of a second side on the backlight surface of the semiconductor substrate to the finger adjacent thereto. The light receiving surface generally refers to a front surface of the solar cell, and the backlight surface generally refers to a rear surface of the solar cell.

In some embodiments, distances from the finger to two adjacent fingers on the other surface are equal.

In some embodiments, the electrical connection electrode line has a width ranging from 10 $\mu$m to 500 $\mu$m.

In some embodiments, a cross section of each of the plurality of electrical connection electrode lines has a shape of a square, an ellipse or a non-standard polygon.

In some embodiments, a quantity of the electrical connection electrode lines on a single one of the plurality of fingers is 10 to 50.

In some embodiments, the plurality of electrical connection electrode lines are arranged on the transport electrode line at equal intervals.

In a second aspect, the present disclosure provides a photovoltaic module, the photovoltaic module including at least one solar cell string; a back sheet arranged below the at least one solar cell string; an upper cover plate arranged above the at least one solar cell string; and an adhesive film filled between the back sheet and the at least one solar cell string and between the upper cover plate and the at least one solar cell string. The solar cell is the solar cell described above, and adjacent ones of the solar cells are connected through a plurality of conductive wires to realize electrical connection.

In some embodiments, a length of one of the plurality of electrical connection electrode lines is 0.8-5 times a diameter of the conductive wire.

In some embodiments, the plurality of conductive wires are in one-to-one correspondence to the plurality of electrical connection electrode lines on one of the finger, and one of the plurality of conductive wires has a first end soldered to the electrical connection electrode line on the light receiving surface of one of the plurality of solar cells and a second end soldered to the electrical connection electrode line on the backlight surface of another of the plurality of solar cells.

The above description is only a summary of the technical solutions of the present disclosure. In order to be able to understand the technical means of the present disclosure more clearly, the technical means can be implemented according to the contents of the description. Furthermore, to make the above and other objectives, features and advantages of the present disclosure more comprehensible, specific embodiments of the present disclosure are descried as follows.

**BRIEF DESCRIPTION OF DRAWINGS**

Through reading detailed descriptions of the following embodiments, those of ordinary skill in the art may understand various advantages and benefits. The accompanying drawings are merely intended to illustrate objectives of the embodiments, but are not interpreted as limitations on the present disclosure. In addition, the same reference sign is used to indicate the same member throughout the accompanying drawings.

FIG. 1 is a schematic structural diagram of a light receiving surface of a solar cell according to an embodiment of the present disclosure;
FIG. 2 is a schematic structural diagram of a backlight surface of the solar cell according to an embodiment of the present disclosure;
FIG. 3 is a schematic diagram of a first structural relationship between a transport electrode line and electrical connection electrode lines according to an embodiment of the present disclosure;
FIG. 4 is a schematic diagram of a second structural relationship between the transport electrode line and the electrical connection electrode lines according to an embodiment of the present disclosure;
FIG. 5 is a schematic diagram of a third structural relationship between the transport electrode line and the electrical connection electrode lines according to an embodiment of the present disclosure;
FIG. 6 is a sectional view of solar cells after soldering through conductive wires according to an embodiment of the present disclosure;
FIG. 7 is a schematic diagram of positioning of the conductive wires during manufacturing of a solar cell string according to an embodiment of the present disclosure; and
FIG. 8 is a structural sectional view of a photovoltaic module according to an embodiment of the present disclosure.

In the drawings, the drawings are not necessarily drawn to an actual scale.

**DESCRIPTION OF EMBODIMENTS**

Embodiments of the technical solutions of the present disclosure are described in detail below with reference to the accompanying drawings. The following embodiments are intended only to better illustrate the technical solutions of the present disclosure, and are therefore used only as examples and are not intended to limit the protection scope of the present disclosure.

Unless otherwise defined, all technical and scientific terms used herein have the same meaning as commonly understood by those of ordinary skill in the art to which the present disclosure belongs. The terms used in the specification of the present disclosure are intended only to describe particular embodiments and are not intended to limit the present disclosure. Terms such as "include", "comprise", "have" and other variants thereof in the specification and claims of the present disclosure and the above brief description of drawings are intended to cover a non-exclusive inclusion.

In the description of embodiments of the present disclosure, technical terms "first", "second" and the like are intended only to distinguish different objects, which shall not be construed as indicating or implying a relative importance, or implicitly specifying the number, a particular order or primary and secondary relations of the indicated technical features. In the description of embodiments of the present disclosure, "a plurality of" means two or more, unless specifically stated otherwise.

The "embodiments" mentioned herein means that particular features, structures or characteristics described with reference to the embodiments may be included in one or more embodiments of the present disclosure. Phrases appearing at various positions of the specification neither always refer to the same embodiments, nor separate or alternative embodiments that are mutually exclusive with other embodiments. It is explicitly and implicitly understood by those skilled in the art that the embodiments described herein may be combined with other embodiments.

In the description of embodiments of the present disclosure, the term "and/or" is merely an association relationship describing associated objects, indicating that three relationships may exist. For example, A and/or B indicates that there are three cases of A alone, A and B together, and B alone. In addition, the character "/" herein generally means that associated objects before and after "/" are in an "or" relationship.

In the description of embodiments of the present disclosure, the term "a plurality of" means two or more. Similarly, "a plurality of groups" means two or more groups, and "a plurality of pieces" means two or more pieces.

In the description of embodiments of the present disclosure, the orientation or position relationship indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are only intended to facilitate the description of embodiments of the present disclosure and simplify the description, rather than indicating or implying that the device or element referred to must have a particular orientation or be constructed and operated in a particular orientation, and therefore are not to be interpreted as limitations on the embodiments of the present disclosure.

In the description of embodiments of the present disclosure, unless specifically stated and limited, the technical terms "mounting," "coupling", "connecting" and "fixing" should be understood in a broad sense, such as, a fixed connection, a detachable connection, or an integral connection; a mechanical connection or an electrical connection; a direct connection, an indirect connection through an intermediate medium, an internal connection of two elements, or an interaction of two elements. For those of ordinary skill in the art, the specific meanings of the above terms in embodiments of the present disclosure can be understood on case-by-case.

Currently, a conventional solar cell is designed with 5 to 9 busbars, which is referred to as a multi-busbar (MBB) solar cell. Then, a conductive wire 3 and the busbars of the solar cell are soldered to be connected in series to form a solar cell string, so as to form a photovoltaic module. The conventional approach may have the following problems. More busbars are used, and thus more silver paste is used, which greatly increases material costs of the silver paste. The silver paste is a precious metal, which, as one of the electrode materials of solar cells, accounts for a large proportion of its costs.

Based on the above defects of the MBB technology, the inventor noted that purposes of reducing costs and increasing efficiency may be achieved by optimizing a pattern of a solar cell without changing an interconnection process of the solar cell.

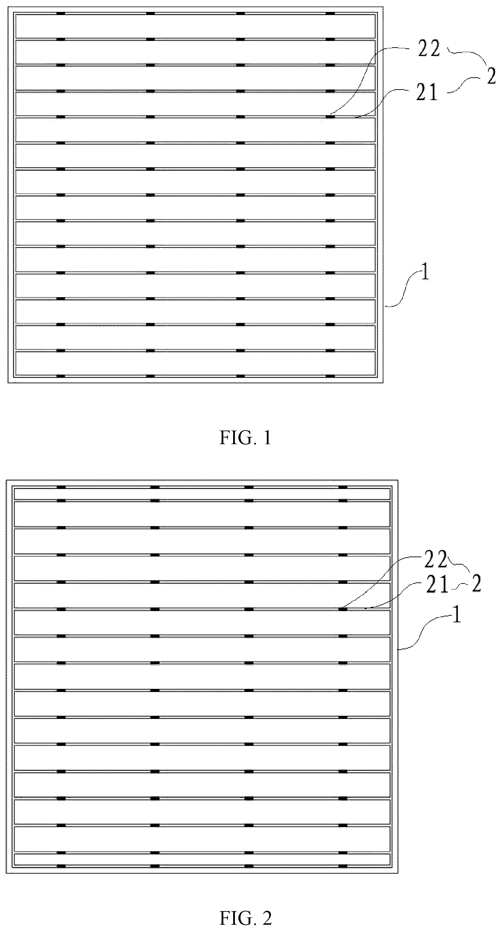

Referring to FIG. 1 and FIG. 2, FIG. 1 is a schematic structural diagram of a light receiving surface of a solar cell according to an embodiment of the present disclosure; and FIG. 2 is a schematic structural diagram of a backlight surface of the solar cell according to an embodiment of the present disclosure.

The present disclosure provides a solar cell, including a semiconductor substrate 1 and an electrode arranged on the semiconductor substrate 1. A diffusion layer is diffused on a light receiving surface of the semiconductor substrate 1. At the same time, a front passivation layer is formed on one side of the diffusion layer facing away from the semiconductor substrate 1, and a back passivation layer is formed on a back surface of the semiconductor substrate 1. A front electrode is formed on one side of the front passivation layer facing away from the semiconductor substrate 1, and a back electrode is formed on one side of the back passivation layer facing away from the semiconductor substrate 1.

The electrode includes a plurality of fingers 2 arranged in parallel to and spaced apart from each other. The finger 2 includes a transport electrode line 21 and a plurality of electrical connection electrode lines 22 in contact with the transport electrode line 21. In a thickness direction of the semiconductor substrate 1, the plurality of fingers 2 on the light receiving surface of the semiconductor substrate 1 are staggered with a plurality of fingers 2 on a backlight surface of the semiconductor substrate 1.

In an embodiment, the semiconductor substrate 1 is made of a silicon wafer material. The finger 2 is printed and sintered by silver paste. In addition, details may be obtained with reference to the related art, which are not further expanded herein.

A common solar cell includes an N-type photovoltaic cell and a P-type photovoltaic cell. The N-type photovoltaic cell has a longer service life and higher efficiency. The P-type photovoltaic cell has a simple process and lower costs.

The N-type photovoltaic cell includes N-type silicon wafers and conducts electricity by electrons. The P-type photovoltaic cell includes P-type silicon wafers and conducts electricity by holes. In general, the N-type photovoltaic cell is provided with silver paste on two sides. In one possible embodiment, the N-type photovoltaic cell may be a Tunnel Oxide Passivated Contact (TOPCon) cell. A base of the TOPCon solar cell is an N-type semiconductor (semiconductor substrate 1). In the base, a back side is successively provided with an ultrathin tunnel oxide layer, an N-type polysilicon, a backside passivation layer and a metal electrode, and the other side is provided with a boron-doped diffusion layer and a metal electrode.

In the P-type photovoltaic cell, one side is made of silver paste, and the other side is made of aluminum paste and silver paste in combination. In one possible embodiment, the P-type photovoltaic cell may be a Passivated Emitter and Rear Contact (PERC) cell. A base of the P-type photovoltaic cell is a P-type semiconductor (semiconductor substrate 1). Moreover, in the base, a front side provided with a passivation layer and a silver electrode, and the other side is provided with a passivation layer, an aluminum electrode and a silver electrode.

In some embodiments, the finger 2 is provided as a transport electrode line 21 and a plurality of electrical connection electrode lines 22 in contact with the transport electrode line 21. The transport electrode line 21 is configured to collect carriers on a surface of the solar cell. The electrical connection electrode lines 22 are configured to realize electrical connection after being soldered to conductive wires 3. A plurality of adjacent solar cells are formed as a solar cell string together. Adjacent solar cells are connected through the conductive wires 3 to realize electrical connection.

A plurality of solar cells form a solar cell string, and adjacent solar cells are connected through the conductive wires 3 to realize current transfer. The conductive wires 3 are successively solder to the electrical connection electrode lines 22 of the plurality of fingers 2. A single one of the conductive wires 3 has a first end soldered to the electrical connection electrode line 22 on the light receiving surface of one of the solar cells and a second end soldered to the electrical connection electrode line 22 on the backlight surface of the other of the solar cells. In an embodiment, extension directions of the fingers 2 and the conductive wires are perpendicular to each other. The plurality of fingers 2 are communicated through a plurality of columns of parallel conductive wires 3, which may effectively optimize a current transfer path, improve effective conduction of currents, and prevent the influence of electrode line breakage on current collection.

In the present disclosure, the busbars in the conventional art are replaced with the conductive wires 3, thereby reducing consumption of the silver paste and reducing manufacturing costs. At the same time, the solar cell is less affected by micro-cracks and other problems, which improves reliability of the product and may effectively prevent the influence of electrode line breakage on the solar cell.

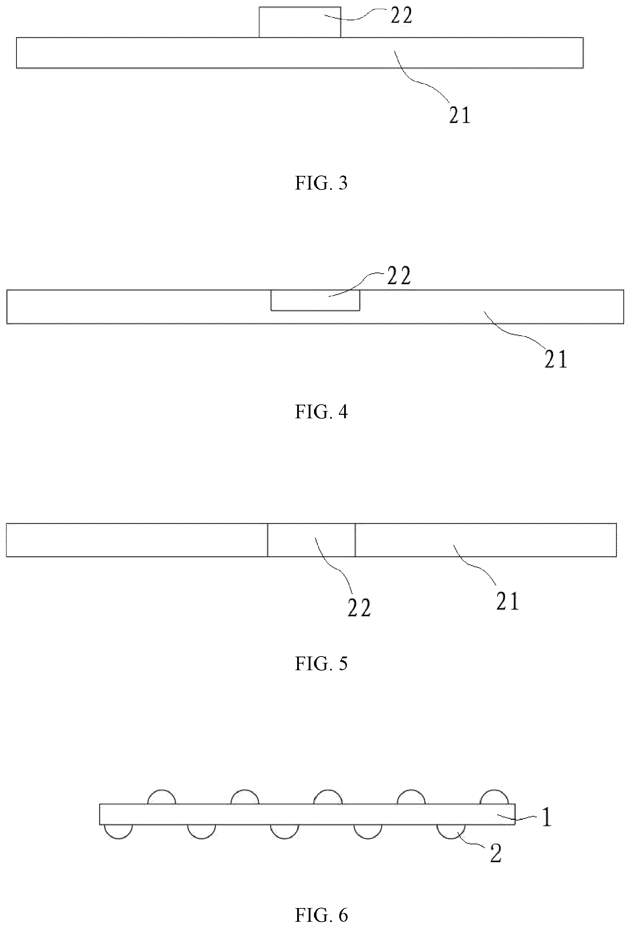

Referring to FIG. 3 to FIG. 5, FIG. 3 is a schematic diagram of a first structural relationship between a transport electrode line 21 and electrical connection electrode lines 22 according to an embodiment of the present disclosure; FIG. 4 is a schematic diagram of a second structural relationship between the transport electrode line 21 and the electrical connection electrode lines 22 according to an embodiment of the present disclosure; and FIG. 5 is a schematic diagram of a third structural relationship between the transport electrode line 21 and the electrical connection electrode lines 22 according to an embodiment of the present disclosure.

The electrical connection electrode lines 22 are arranged on the transport electrode line 21 by screen printing, which may be implemented with reference to the manufacturing process in the related art and is not described in detail here. The electrical connection electrode lines 22 may contact the transport electrode line 21 in many forms, which may be arranged on a surface of the transport electrode line 21 as shown in FIG. 3, or semi-embedded in the transport electrode line 21 as shown in FIG. 4, or fully embedded in the transport electrode line 21 as shown in FIG. 5. Those skilled in the art know that the electrical connection electrode lines 22 may be arranged in more transformed manners, provided that top surfaces of the electrical connection electrode lines 22 can be connected to the conductive wires 3 and no electrode line breakage occurs in the finger 2. Carriers on the surface of the solar cell can be transported successively through the transport electrode line 21 and the electrical connection electrode lines 22 to the conductive wires 3, which replace the busbars in the conventional solar cell to collect and transfer currents collected by the finger 2.

For the electrical connection electrode lines 22 and the transport electrode line 21, the electrical connection electrode lines 22 are printed on the transport electrode line 21 by double-layer printing, which effectively reduces consumption of silver paste, achieves similar carrier collection efficiency. Finally, the fingers 2 are connected together through the conductive wires 3. Paste of the electrical connection electrode lines 22 does not form ohmic contact with a silicon substrate, which reduces an area of a sintering region and recombination of carriers in the region, helps to improve an open-circuit voltage of the solar cell and achieves higher conversion efficiency.

At the same time, a plurality of fingers 2 on the light receiving surface of the semiconductor substrate 1 are staggered with a plurality of fingers 2 on the backlight surface of the semiconductor substrate 1. Referring to FIG. 6, FIG. 6 is a sectional view of solar cells after soldering through conductive wires 3 according to an embodiment of the present disclosure. Since the fingers 2 on two sides of the semiconductor substrate 1 are staggered, orthographic projections of the plurality of fingers 2 on the light receiving surface of the semiconductor substrate 1 on the semiconductor substrate 1 and orthographic projections of the plurality of fingers 2 on the backlight surface of the semiconductor substrate 1 on the semiconductor substrate 1 have no overlapping, so that contact points of a plurality of conductive wires 3 on the light receiving surface of the semiconductor substrate 1 are staggered with contact points of a plurality of conductive wires 3 on the backlight surface of the substrate, thereby reducing micro-cracks of the solar cell during subsequent soldering and lamination, reducing the stress at junctions between the solar cell and the conductive wires 3, and reducing a debris rate.

In a soldering stage, the solar cell is sucked by a soldering platform. At the same time, the conductive wires may be pressed by a positioning fixture near electrode pads to press the conductive wire against the surface of the solar cell. Upon completion of the soldering, solder balls are formed at positions of the electrode pads on the front and back surfaces of the solar cell. The presence of the solder balls may lead to a height difference on the back surface of the solar cell. At the same time, due to the presence of pressure applied by the positioning fixture, if the electrode pads on the front and back surfaces of the solar cell correspond to each other, pressure points may be concentrated here, and the electrode pads are prone to micro-cracks. As shown in FIG. 6, in some embodiments, a plurality of fingers 2 on the light receiving surface of the semiconductor substrate 1 are staggered with a plurality of fingers 2 on the backlight surface of the semiconductor substrate 1, that is, the electrode pads on the front and back surfaces of the solar cell are staggered. During soldering, the pressure may be evenly distributed on the semiconductor substrate 1, which reduces local force, thereby reducing the debris rate.

In a lamination stage, lamination is a process of extrusion for laminates. A volume of an ethylene vinyl acetate (EVA) adhesive film is continuously compressed, and the pressure of lamination is evenly distributed on the semiconductor substrate 1 by misaligning the electrode pads on the front and back surface of the solar cell, which reduces local force, thereby reducing the debris rate.

Refer to the following table for specific performance indicators.

|  | Original design | Solution of the present disclosure |
|---|---|---|
| Soldering debris rate | 0.43% | 0.29% |
| Lamination debris rate | 0.38% | 0.21% |
| Total | 0.81% | 0.50% |

As can be seen from the above table, by using the misalignment process, the stress is evenly distributed during the soldering or lamination, so that the soldering debris rate and the lamination debris rate of the conductive wire 3 can be reduced, which effectively improves a yield of the photovoltaic module, and improves the quality of products and reduces manufacturing costs.

According to some embodiments of the present disclosure, for example, a size of the electrode satisfies a first formula.

The first formula includes:

$$L1+2 \text{ mm} \geq L1' \geq L1+0.5 \text{ mm, and } L2-2 \text{ mm} \leq L2' \leq L2-0.5 \text{ mm}.$$

At the same time, in an embodiment, the size of the electrode satisfies a second formula.

The second formula includes:

$$L1+L2= L1'+L2'.$$

L1 represents a spacing between an edge of a first side on the light receiving surface of the semiconductor substrate 1 to the finger 2 adjacent thereto, L2 represents a spacing between an edge of a second side on the light receiving surface of the semiconductor substrate 1 to the finger 2 adjacent thereto, L1' represents a spacing between an edge of a first side on the backlight surface of the semiconductor substrate 1 to the finger 2 adjacent thereto, and L2' represents a spacing between an edge of a second side on the backlight surface of the semiconductor substrate 1 to the finger 2 adjacent thereto.

Referring to FIG. 1 and FIG. 2, the first side on the light receiving surface of the semiconductor substrate 1 refers to an upper side as illustrated, and the second side on the light receiving surface of the semiconductor substrate 1 refers to a lower side as illustrated. Extension directions of the first side and the second side are parallel to those of the fingers 2. The first side and the second side on the backlight surface of the semiconductor substrate 1 are also defined in the same way. At a starting position, distances from the fingers 2 on the light receiving surface and the backlight surface of the semiconductor substrate 1 to the sides of the semiconductor substrate 1 respectively are not equal, while distances between adjacent fingers 2 are the same, and the extension directions are parallel, as shown in FIG. 6. Therefore, the fingers 2 throughout the light receiving surface and the backlight surface of the semiconductor substrate 1 are staggered.

A spacing between orthographic projections of two adjacent fingers 2 on the light receiving surface and the backlight surface of the semiconductor substrate 1 in a normal line direction of the semiconductor substrate 1 ranges from 1 mm to 50 mm. If the spacing is excessively small, the solar cell is seriously shielded and difficult to solder, and interference between electrode pads on the two adjacent fingers 2 is easy. If the spacing is excessively large, the loss is high and the efficiency of the solar cell is low. In an embodiment, the spacing is 20 mm, which ensures higher efficiency of the solar cell and prevents excessive shielding on the surface of the semiconductor substrate 1. Those skilled in the art may know that the spacing may be determined according to an actual manufacturing process, which is not limited herein.

In an embodiment, distances from the finger 2 to two adjacent fingers 2 on the other surface are equal. That is, an orthographic projection of the finger 2 on the light receiving surface of the semiconductor substrate 1 in the normal line direction of the semiconductor substrate 1 are located between two fingers 2 on the backlight surface, so that a contact point on the light receiving surface of the semiconductor substrate 1 is also located between two contact points on the backlight surface. The same is true for the finger 2 on the backlight surface of the semiconductor substrate 1, so that the stress during the soldering or lamination is distributed more evenly, thereby further reducing the debris rate of the conductive wire 3.

In an embodiment, the electrical connection electrode line 22 has a width ranging from 10 $\mu$m to 500 $\mu$m, which is, for example, 200 $\mu$m. If the electrical connection electrode line 22 is excessively narrow, the loss is high and the efficiency of the solar cell is low. If the electrical connection electrode line 22 is excessively wide, the solar cell is seriously shielded, and the conversion efficiency of the whole solar cell is reduced. Therefore, in some embodiments, the width of the electrical connection electrode line 22 is 200 $\mu$m, so as to effectively reduce series resistance, improve the efficiency of the solar cell (by 0.05%-0.15%), reduce attenuation of the solar cell, effectively increase an absorption rate of the solar cell, and improve the conversion efficiency of the overall solar cell. Similarly, in an embodiment, the width of the transport electrode line 21 is also 200 $\mu$m, which is consistent with the electrical connection electrode line 22, so as to facilitate the molding of the finger 2.

In an embodiment, a cross section of the electrical connection electrode line 22 includes a square, an ellipse or a non-standard polygon. The electrical connection electrode lines 22 in a shape of a square, a circle or an ellipse with a larger area or more non-standard polygons are stacked on the transport electrode line, thereby increasing contact areas of the electrode pads and heights of the electrode pads, and reducing abnormal soldering between the conductive wire 3 and the solar cell during soldering of the conductive wire 3. Those skilled in the art may know that the electrical connection electrode lines 22 may have more widths and patterns, which are not limited herein.

In an embodiment, a number of the electrical connection electrode lines 22 on a single one of the fingers 2 is 10 to 50. The number and density of distribution of the electrical connection electrode lines 22 are set according to power of generation to achieve maximum current collection. This range is based on comprehensive consideration of, for example, resistance of the electrode, a light-shielding area of the electrode and a yield of the electrode, enabling high photoelectric conversion efficiency and a high yield. Each electrical connection electrode line 22 corresponds to a conductive wire 3, so that a number of conductive wires 3 on a single solar cell is also 10 to 50. The number of the conductive wire 3 is increased, and the width of the conductive wire 3 is reduced, thereby reducing resistance loss, increasing power of the module, reducing the consumption of precious metal silver, reducing costs of the module and preventing a risk caused by poor soldering of electrode pads.

In an embodiment, the plurality of electrical connection electrode lines 22 are arranged on the transport electrode line 21 at equal intervals, so that the two adjacent conductive wires 3 are also equally spaced, which may better form contact points, preventing deviation of soldering and improving performance of soldering.

Based on the above solder cell, the present disclosure further provides a solar cell string, including a plurality of solar cells. Adjacent ones of the solar cells are connected through a plurality of conductive wires 3 to realize electrical connections.

In a same row of solar cells, the conductive wires 3 are soldered between a front surface of one solar cell and a back surface of another solar cell adjacent thereto. Therefore, the solar cells in the same row are connected in series, and a plurality of solar cell strings are then connected in parallel.

In some specific embodiments, a manufacturing process of a solar cell string includes: laying a solar cell at the head first, then laying a first end of a conductive wire 3 on the solar cell at the head, a number of the conductive wire 3 is consistent with that of electrical connection electrode lines 22 on each finger 2 of the solar cell, and enabling a second end of the conductive wire 3 to fall behind the solar cell; laying a next solar cell, enabling the solar cell to cover the second end of the laid conductive wire 3, and then laying a next conductive wire 3 on the solar cell, so that a solar cell and a conductive wire 3 are laid successively, to finally form the solar cell string.

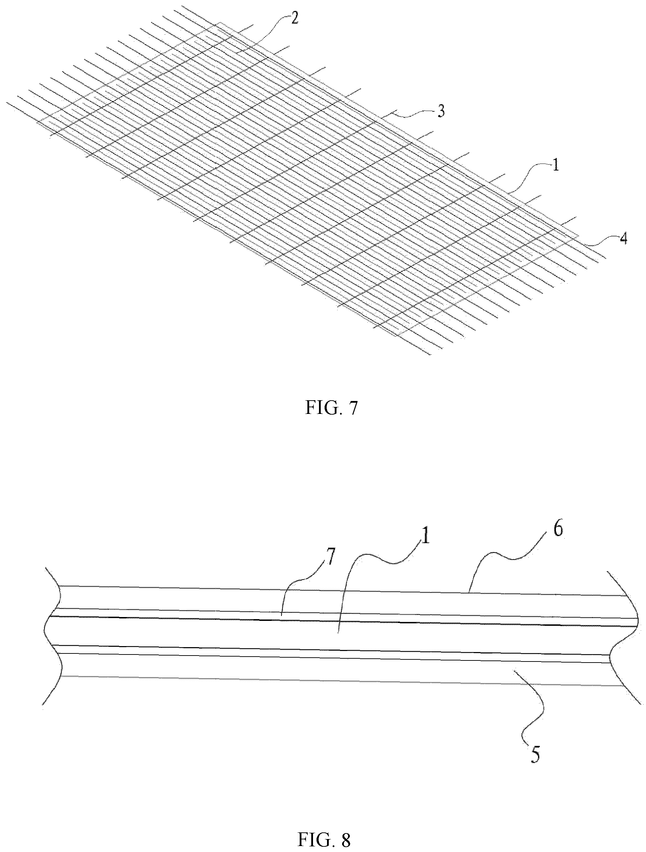

During the soldering of the conductive wire 3, a positioning fixture may be used for positioning. Referring to FIG. 7, FIG. 7 is a schematic diagram of positioning of the conductive wires during manufacturing of a solar cell string according to an embodiment of the present disclosure. Upon completion of layout of the conductive wires 3 on the front surface of the solar cell, the conductive wires 3 are positioned through the positioning fixture. The positioning fixture includes N metal wires 4. Extension directions of the metal wires 4 are perpendicular to extension directions of the conductive wires 3. The metal wires 4 press a plurality of conductive wires 3 on the solar cell to prevent deformation of the conductive wires 3. The metal wires 4 are distributed on two sides of a crossed soldering region between the conductive wire 3 and the finger 2 to ensure that each conductive wire 3 is in good contact with the finger 2. A number of the metal wires 4 may be greater than or equal to 1/2 of the number of the finger 2 and less than or equal to 1.5 times the number of the finger 2.

The metal wire 4 is made of a material with poor solderability, which may be made of a stainless steel, aluminum or aluminum alloy material. Those skilled in the art may know that the positioning fixture may include metal wires as well as, for example, an indenter or a mesh wire.

In an embodiment, a length of a single electrical connection electrode line 22 is 1-5 times a diameter of the conductive wire 3. The length of the electrical connection electrode line refers to a size of the electrical connection electrode line along the length of the conductive wire. The length of the electrical connection electrode line 22 is set to be greater than the width of the conductive wire 3, so that the conductive wire 3 is easy to align with the electric connection lines 22 when the conductive wire 3 are soldered to the solar cells in series.

Based on the solar cell string described above, the present disclosure further provides a photovoltaic module. Referring to FIG. 8, FIG. 8 is a structural sectional view of a photovoltaic module according to an embodiment of the present disclosure. The photovoltaic module includes a back sheet 5, an upper cover plate 6, an adhesive film 7 and at least one solar cell string. The back sheet 5 is arranged below the solar cell string, the upper cover plate 6 is located above the solar cell string, and the adhesive film 7 is filled between the back sheet 5 and the solar cell string as well as between the upper cover plate 6 and the solar cell string.

The upper cover plate 6 is configured to protect the solar cell string, and the back sheet 5 is mainly configured for sealing, insulation and water resistance, which are, for example, glass plates. Transparent sheets, for example, glass plates, are preferred.

The adhesive film 7 is configured to bond and fix the upper cover plate 6, the solar cell string and the back sheet 5. For example, the adhesive film 7 is made of polyethylene octene co-elastomer (POE) and/or EVA. In the present disclosure, POE and EVA may be prepared with a common product in the art or according to a method well known to those skilled in the art.

In the technical solutions of embodiments of the present disclosure, structures of the fingers 2 are optimized, so that the fingers 2 are arranged as a transport electrode line 21 and a plurality of electrical connection electrode lines 22 in contact with the transport electrode line 21, and the conductive wires 3 are successively soldered to the electrical connection electrode lines 22 of a plurality of the fingers 2 to realize current transfer, so as to remove all busbars from a conventional solar cell. A busbar-free module may be manufactured using an existing packaging process, and at the same time, purposes of reducing light shielding of a surface of the solar cell and consumption of silver paste and ensuring reliability of soldering of the solar cell are achieved.

Finally, it is to be noted that the above embodiments are merely intended for describing the technical solutions of the present disclosure rather than limiting the present disclosure. Although the present disclosure is described in detail with reference to the above embodiments, those of ordinary skill in the art should understand that they may still make modifications to the technical solutions described in the above embodiments or make equivalent replacements to some or all of the technical features thereof, and such modifications or replacements do not cause the essence of the corresponding technical solutions to depart from the scope of the technical solutions of the embodiments of the present disclosure, all of which should fall within the scope of the claims and description of the present disclosure. In particular, the technical features mentioned in various embodiments can be combined in any manner provided that there is no structural conflict. The present disclosure is not limited to the specific embodiments disclosed herein, but includes all technical solutions falling into the protection scope of the claims.

**Claims**

1. A solar cell, **characterized by** comprising:

   a semiconductor substrate, and
   an electrode arranged on the semiconductor substrate,
   wherein the electrode comprises a plurality of fingers arranged in parallel to and spaced apart from each other,
   wherein each finger of the plurality of finger comprises a transport electrode line and a plurality of electrical connection electrode lines in contact with the transport electrode line, and in a thickness direction of the semiconductor substrate, a plurality of fingers arranged on a light receiving surface of the semiconductor substrate are staggered with a plurality of fingers arranged on a backlight surface of the semiconductor substrate.

2. The solar cell according to claim 1, **characterized in that**, a size of the electrode satisfies:

   $L1+2 \text{ mm} \geq L1' \geq L1+0.5 \text{ mm}$, and $L2-2 \text{ mm} \leq L2' \leq L2-0.5 \text{ mm}$;
   where L1 represents a spacing between an edge of a first side on the light receiving surface of the semiconductor substrate to the finger adjacent thereto, L2 represents a spacing between an edge of a second side on the light receiving surface of the semiconductor substrate to the finger adjacent thereto, L1' represents a spacing between an edge of a first side on the backlight surface of the semiconductor substrate to the finger adjacent thereto, and L2' represents a spacing between an edge of a second side on the backlight surface of the semiconductor substrate to the finger adjacent thereto.

3. The solar cell according to claim 1, **characterized in that**, distances from the finger to two adjacent fingers on the other surface are equal.

4. The solar cell according to claim 1, **characterized in that**, the electrical connection electrode line has a width ranging

from 10 μm to 500 μm.

5. The solar cell according to claim 1, **characterized in that**, a cross section of each of the plurality of electrical connection electrode lines has a shape of a square, an ellipse or a non-standard polygon.

6. The solar cell according to claim 1, **characterized in that**, a quantity of the electrical connection electrode lines on a single one of the plurality of fingers is 10 to 50.

7. The solar cell according to claim 1, **characterized in that**, the plurality of electrical connection electrode lines are arranged on the transport electrode line at equal intervals.

8. A photovoltaic module, **characterized by** comprising:

at least one solar cell string;
a back sheet arranged below the at least one solar cell string;
an upper cover plate arranged above the at least one solar cell string; and
an adhesive film filled between the back sheet and the at least one solar cell string and between the upper cover plate and the at least one solar cell string,
wherein the solar cell string comprises a plurality of solar cells, at least one of the plurality of solar cell is the solar cell according to any one of claims 1 to 7, and adjacent ones of the plurality of solar cells are connected through a plurality of conductive wires to realize electrical connections.

9. The photovoltaic module according to claim 8, **characterized in that**, a length of one of the plurality of electrical connection electrode lines is 0.8-5 times a diameter of the conductive wire.

10. The photovoltaic module according to claim 8, **characterized in that**, the plurality of conductive wires are in one-to-one correspondence to the plurality of electrical connection electrode lines on one of the finger, and one of the plurality of conductive wires has a first end soldered to the electrical connection electrode line on the light receiving surface of one of the plurality of solar cells and a second end soldered to the electrical connection electrode line on the backlight surface of another of the plurality of solar cells.


**Amended claims in accordance with Rule 137(2) EPC.**

1. A solar cell, **characterized by** comprising:

a semiconductor substrate (1), and
an electrode arranged on the semiconductor substrate (1),
wherein the electrode comprises a plurality of fingers (2) arranged in parallel to and spaced apart from each other, wherein each finger (2) of the plurality of finger (2) comprises a transport electrode line (21) and a plurality of electrical connection electrode lines (22) in contact with the transport electrode line (21), and in a thickness direction of the semiconductor substrate (1), at least two fingers (2) of the plurality of fingers (2) that are arranged on a light receiving surface of the semiconductor substrate (1) are staggered with another at least two fingers (2) of the plurality of fingers (2) that are arranged on a backlight surface of the semiconductor substrate (1); and
wherein the plurality of electrical connection electrode lines (22) is stacked on the transport electrode line (21) in the thickness direction of the semiconductor, or is semi-embedded in the transport electrode line, or fully embedded in the transport electrode line (21).

2. The solar cell according to claim 1, **characterized in that**, a size of the electrode satisfies:

L1+2 mm≥L1'≥L1+0.5 mm, and L2-2 mm≤L2'≤L2-0.5 mm;
where L1 represents a spacing between an edge of a first side on the light receiving surface of the semiconductor substrate (1) to the finger (2) adjacent thereto, L2 represents a spacing between an edge of a second side on the light receiving surface of the semiconductor substrate (1) to the finger (2) adjacent thereto, L1' represents a spacing between an edge of a first side on the backlight surface of the semiconductor substrate (1) to the finger (2) adjacent thereto, and L2' represents a spacing between an edge of a second side on the backlight surface of the semiconductor substrate (1) to the finger (2) adjacent thereto.

3. The solar cell according to claim 1, **characterized in that**, distances from one figure of the plurality of fingers (2) on one of the light receiving surface and the backlight surface to two fingers (2) of the plurality of fingers (2) that are adjacent to the figure and are located on the other one of the light receiving surface and the backlight surface are equal.

4. The solar cell according to claim 1, **characterized in that**, the electrical connection electrode line (22) has a width ranging from 10 μm to 500 μm.

5. The solar cell according to claim 1, **characterized in that**, the electrical connection electrode line (22) has a width ranging from 10 μm to 200 μm.

6. The solar cell according to claim 1, **characterized in that**, a cross section of each of the plurality of electrical connection electrode lines (22) has a shape of a square, an ellipse or an irregular polygon.

7. The solar cell according to claim 1, **characterized in that**, a quantity of the electrical connection electrode lines (22) on a single one of the plurality of fingers (2) is 10 to 50.

8. The solar cell according to claim 1, **characterized in that**, the plurality of electrical connection electrode lines (22) are arranged on the transport electrode line (21) at equal intervals.

9. A photovoltaic module, **characterized by** comprising:

   at least one solar cell string;
   a back sheet (5) arranged below the at least one solar cell string;
   an upper cover plate (6) arranged above the at least one solar cell string; and
   an adhesive film (7) filled between the back sheet (5) and the at least one solar cell string and between the upper cover plate (6) and the at least one solar cell string,
   wherein the solar cell string comprises a plurality of solar cells, at least one of the plurality of solar cell is the solar cell according to claim 1, and adjacent ones of the plurality of solar cells are connected through a plurality of conductive wires (4) to realize electrical connections.

10. The photovoltaic module according to claim 9, **characterized in that**, a length of one of the plurality of electrical connection electrode lines (22) is 0.8-5 times a diameter of the conductive wire (4).

11. The photovoltaic module according to claim 9, **characterized in that**, the plurality of conductive wires (4) are in one-to-one correspondence to the plurality of electrical connection electrode lines (22) on one of the finger (2), and one of the plurality of conductive wires (4) has a first end soldered to the electrical connection electrode line (22) on the light receiving surface of one of the plurality of solar cells and a second end soldered to the electrical connection electrode line (22) on the backlight surface of another of the plurality of solar cells.

12. The photovoltaic module according to claim 9, **characterized in that**, a size of the electrode satisfies:

   L1+2 mm≥L1'≥L1+0.5 mm, and L2-2 mm≤L2'≤L2-0.5 mm;
   where L1 represents a spacing between an edge of a first side on the light receiving surface of the semiconductor substrate (1) to the finger (2) adjacent thereto, L2 represents a spacing between an edge of a second side on the light receiving surface of the semiconductor substrate (1) to the finger (2) adjacent thereto, L1' represents a spacing between an edge of a first side on the backlight surface of the semiconductor substrate (1) to the finger (2) adjacent thereto, and L2' represents a spacing between an edge of a second side on the backlight surface of the semiconductor substrate (1) to the finger (2) adjacent thereto.

13. The photovoltaic module according to claim 9, **characterized in that**, distances from one figure of the plurality of fingers (2) on one of the light receiving surface and the backlight surface to two fingers (2) of the plurality of fingers (2) that are adjacent to the figure and are located on the other one of the light receiving surface and the backlight surface are equal.

14. The photovoltaic module according to claim 9, **characterized in that**, a quantity of the electrical connection electrode lines (22) on a single one of the plurality of fingers (2) is 10 to 50.

15. The photovoltaic module according to claim 9, **characterized in that**, the plurality of electrical connection electrode lines (22) are arranged on the transport electrode line (21) at equal intervals.

FIG. 1

FIG. 2

FIG. 3

FIG. 4

FIG. 5

FIG. 6

FIG. 7

FIG. 8

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2008 235354 A (SANYO ELECTRIC CO) 2 October 2008 (2008-10-02) * Figures 1,4,7-12 and corresponding passages of the description. * ----- | 1-10 | INV. H01L31/0224 H01L31/05 |
| X | US 2015/372183 A1 (JIN YOONSIL [KR] ET AL) 24 December 2015 (2015-12-24) * the whole document * ----- | 1-10 | |
| X | US 2012/312367 A1 (JIN YOONSIL [KR] ET AL) 13 December 2012 (2012-12-13) * the whole document * ----- | 1-10 | |

TECHNICAL FIELDS
SEARCHED     (IPC)

H01L

The present search report has been drawn up for all claims

| Place of search | Date of completion of the search | Examiner |
|---|---|---|
| Berlin | 27 April 2022 | Voignier, Vincent |

## ANNEX TO THE EUROPEAN SEARCH REPORT
## ON EUROPEAN PATENT APPLICATION NO.

EP 21 21 3757

This annex lists the patent family members relating to the patent documents cited in the above-mentioned European search report.
The members are as contained in the European Patent Office EDP file on
The European Patent Office is in no way liable for these particulars which are merely given for the purpose of information.

27-04-2022

| Patent document cited in search report | | Publication date | Patent family member(s) | | Publication date |
|---|---|---|---|---|---|
| JP 2008235354 | A | 02-10-2008 | JP | 4974722 B2 | 11-07-2012 |
| | | | JP | 2008235354 A | 02-10-2008 |
| US 2015372183 | A1 | 24-12-2015 | CN | 102983209 A | 20-03-2013 |
| | | | EP | 2568511 A2 | 13-03-2013 |
| | | | KR | 20130027301 A | 15-03-2013 |
| | | | US | 2013056051 A1 | 07-03-2013 |
| | | | US | 2015372183 A1 | 24-12-2015 |
| US 2012312367 | A1 | 13-12-2012 | EP | 2535942 A2 | 19-12-2012 |
| | | | KR | 20120137821 A | 24-12-2012 |
| | | | US | 2012312367 A1 | 13-12-2012 |
| | | | US | 2019088805 A1 | 21-03-2019 |

EPO FORM P0459

For more details about this annex : see Official Journal of the European Patent Office, No. 12/82